Europäisches Patentamt

European Patent Office

Office européen des brevets

(11) Publication number: **0 372 812**
**A2**

# EUROPEAN PATENT APPLICATION

(21) Application number: 89312424.8

(51) Int. Cl.⁵: **G01N 29/00**

(22) Date of filing: 29.11.89

(30) Priority: 02.12.88 US 279882

(43) Date of publication of application:
**13.06.90 Bulletin 90/24**

(84) Designated Contracting States:
**DE FR GB**

(71) Applicant: Hewlett-Packard Company
3000 Hanover Street
Palo Alto California 94304(US)

(72) Inventor: Keely, Catherine A.
22801 Longdown Road
Cupertino California 95014(US)

(74) Representative: Colgan, Stephen James et al
CARPMAELS & RANSFORD 43 Bloomsbury
Square
London WC1A 2RA(GB)

(54) Method and apparatus for inspecting solder joints.

(57) A method and apparatus for contactless inspection of solder joints on printed circuit boards. A component lead on a circuit board is stimulated to vibrate and the resulting vibrations are detected by a laser Doppler vibrometer which has no physical contact with the circuit board or the lead. An output indicative of the frequencies of the vibrations is provided by one or more tuned filters or by a spectrum analyzer. Defective solder joints are identified by the presence or absence of certain frequencies in the output.

FIG_ 1

# METHOD AND APPARATUS FOR INSPECTING SOLDER JOINTS

## Background of the Invention

This invention pertains generally to the inspection of electronic assemblies and more particularly to a method and apparatus for contactless inspection of solder joints.

A preferred method of mounting and connecting an electronic component during the manufacture of an electronic device has been to solder a conductor such as a wire lead which extends from the body of the component to a pad on a printed circuit board or the like. In the past, most electronic devices were assembled from discrete components such as resistors, capacitors and transistors. These discrete components typically had only two or three leads and were physically large enough that an assembler could easily position the components on a printed circuit board by hand, for example by inserting each lead into a corresponding hole in the circuit board, and solder them in place by means of a manual soldering iron. The person doing the soldering would observe each solder joint as it was formed, and any defective solder joints would immediately be detected and corrected.

Such hand-assembled circuit boards usually did not have many defective solder joints. Moreover, because only a relatively small number of components could physically fit on a circuit board, it was easy for an inspector to visually scan an entire board and find any defective solder joints which the assembler might have missed.

In time, integrated circuits ("ICs") came into widespread use, displacing many discrete components and greatly increasing the number of soldered connections to be made on a printed circuit board. An IC had five, ten or even twenty leads spaced as little as an eighth of an inch apart, and although an assembler could still accurately position such devices on printed circuit boards by inserting the leads into corresponding holes, manual soldering of so many connections on a board became impractical and was gradually replaced by automated methods such as wave soldering in which all the connections on a printed circuit board are soldered at once by dipping the board, with all the components in place, into a pool of molten solder.

This increasing use of automated soldering techniques resulted in a requirement for more careful and systematic inspection of the solder joints because the assembler no longer inspected each joint as it was made. In addition, the increased number of connections on a circuit board made it difficult for an inspector to detect defective solder joints merely by casually scanning the completed board.

Thus, although visual inspection of the soldered connections on printed circuit boards was still feasible, such inspection became more and more time-consuming and therefore costly as the density of connections on printed circuit boards continued to increase. Accordingly, some early efforts were directed toward the development of automated methods of inspecting solder joints. These methods typically required some kind of physical contact between the component leads and the testing device and had limited success.

With continued advances in electronic component packaging, the physical size of many discrete components has become so small that it is now very difficult for human fingers to grip them. In addition, the scale of electronic integration has advanced to the point where a state-of-the-art IC comes in a package which has as many as 50 or 60 leads and which is considerably smaller than older-generation ICs. The spacing between adjacent leads of such new IC packages is of the order of 0.05 inches or less.

It is no longer possible for an assembler even to accurately position such tiny components on printed circuit boards, much less to solder them in place, and this situation has led to new ways of mounting such components on printed circuit boards. The traditional method of inserting component leads into holes in the board and then applying molten solder (either by hand or by wave solder machine) has given way to surface mount techniques in which there are no holes in the printed circuit board. Instead, a thin coating of solder is pre-applied to the pads, the components are placed on the surface of the board with their leads in alignment with the pads, and then the entire board is baked in an oven at a temperature high enough to melt the solder and thereby solder the leads to the pads.

To facilitate the use of surface mount techniques, many components are now manufactured with leads shaped to simplify the placement of the component on a circuit board. Some examples of such lead shapes include the J-shape and the gull-wing shape.

Not only is it no longer possible to manually install state-of-the-art components on printed circuit boards, but it also is no longer feasible to visually inspect the connections on such boards. Accordingly there has been increasing interest in automated methods of inspecting solder joints.

One method which has been explored, as mentioned briefly above, involves physical contact between a lead and a testing device. This method, which is an offshoot of more generalized research regarding automated methods of testing welds and bonds, typically includes the use of acoustic waves. An example of the application of this method to the inspection of solder joints is disclosed in U. S. Patent 4,287,766 issued to Ensminger on September 8, 1981. An acoustic wave is applied to a solder joint and is modulated by the structure of the joint; the modulated wave is received by a transducer in physical contact with the joint and analyzed to determine whether the joint is acceptable.

Another method involves the application of electrical signals to various points on the circuit board and analysis of resulting signals at other points on the board.

Each of these methods has met with some success, but each suffers from such drawbacks as mechanical and electrical complexity, high cost, difficulty of use, and inaccuracy. The effects of these drawbacks, which are in part a consequence of the need for physical contact between the testing apparatus and a large number of points on the board being tested, are especially pronounced when testing circuit boards having very high component densities and assembled by means of surface mount technology. Accordingly, none of these methods has adequately solved the problem of inspecting solder joints on such circuit boards.

It has been suggested that the problems inherent in testing by means of physical contact between the circuit board and the tester can be avoided by contactless testing. An example of this approach is disclosed in U. S. Patent 4,641,527 issued to Ninomiva et al. on February 10, 1987. In this approach, component leads are stimulated by compressed air and a resulting laser speckle pattern is observed.

Another method which has been widely studied involves the use of computer-aided vision. In this approach, an optical image of the circuit board is formed by means of a high-resolution television camera or the like and is then analyzed electronically to determine the quality of the solder joints on the board.

Although contactless inspection methods such as these afford some benefits, they have not solved the problem of providing a fast, reliable and economical method of inspecting solder joints on printed circuit boards.

From the foregoing it will be apparent that there is a need for a fast, reliable and economical way to inspect solder joints on printed circuit boards, especially boards having high component densities and assembled by means of surface mount techniques.

## SUMMARY OF THE INVENTION

The present invention provides a contactless method and apparatus for automatically inspecting solder joints on printed circuit boards, especially boards assembled by surface mount techniques and having very high component densities. By means of the present invention a large number of solder joints on such circuit boards can be inspected rapidly, reliably and economically.

In accordance with the invention, a solder joint with an electrical conductor such as a component lead is inspected by stimulating the lead to vibrate, detecting the vibrations with a detector which is physically isolated from the lead, and providing an output indicative of the quality of the solder joint.

The lead is preferably stimulated by spraying it with a pressurized fluid such as compressed air. The vibrations are detected, for example, by modulating an energy beam such as a laser beam with any vibrations of the lead and detecting the modulations carried by the laser beam. This is preferably done by directing the laser beam against a surface of the lead such that part of the beam is reflected back to the detector. The reflected beam is Doppler-shifted by the vibrating lead, and this Doppler shift is detected and utilized to provide the output. The laser and detector may be comprised in a laser Doppler vibrometer ("LDV") (sometimes referred to as a laser Doppler velocimeter), and a differential vibrometer may be used if desired for improved performance.

The output is preferably an indication of the presence or absence of vibrations at one or more critical frequencies. This output may be provided by a tuned filter or derived from an amplitude-frequency plot of the kind provided by, for example, a spectrum analyzer.

Other aspects and advantages of the present invention will become apparent from the following detailed description, taken in conjunction with the accompanying drawings, illustrating by way of example the principles of the invention.

## BRIEF DESCRIPTION OF THE DRAWINGS

FIGURE 1 is a diagrammatic view of an inspection system according to the invention and having a spectrum analyzer as the output means and an LDV as the detection means;

FIGURE 2 is an amplitude-frequency plot provided by a spectrum analyzer of the kind shown in FIGURE 1 and corresponding with a good solder joint;

FIGURE 3 is an amplitude-frequency plot similar to that shown in FIGURE 2 but corresponding with a defective solder joint; and

FIGURE 4 is a diagrammatic view of an inspection system similar to that of FIGURE 1 but having a plurality of tuned filters as the output means and a differential LDV as the detection means.

## DESCRIPTION OF THE PREFERRED EMBODIMENT

As shown in the drawings for purposes of illustration, the invention is embodied in a contactless solder joint inspection system which includes, for example, a compressed air jet for inducing vibrations in a component lead, a laser Doppler vibrometer ("LDV") for detecting the induced vibrations, and a spectrum analyzer for providing an output indicative of the quality of the solder joint.

In the past, solder joints on printed circuit boards have been inspected visually, but as the component density has increased and surface mount technology has been adopted this method has ceased to be practical. Various attempts have been made to automate the inspection process, but so far only limited success has been achieved.

In accordance with the invention, contactless means are used to detect vibrations in the leads of components on the board, and a filter or a spectrum analyzer provides an output which immediately identifies a defective solder joint. An inspection system according to the invention provides a fast, reliable, easily used and economical means for detecting defective solder joints on state-of-the-art densely populated printed circuit boards.

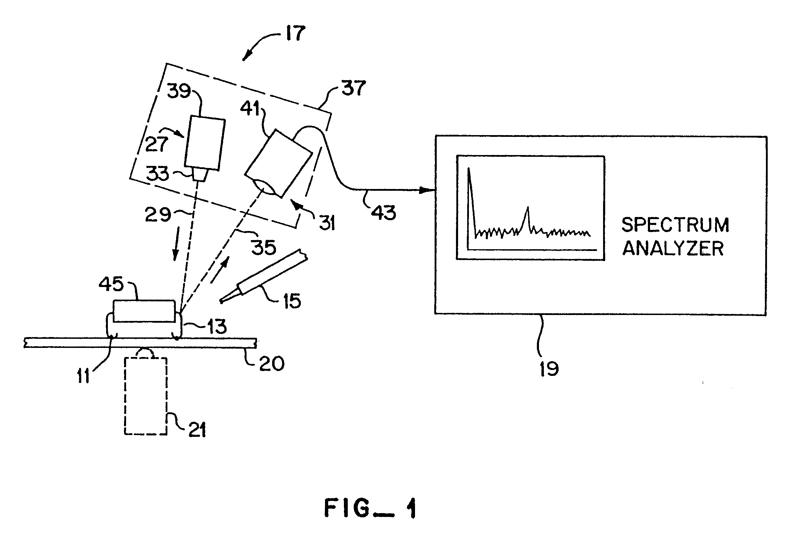

As shown in FIGURE 1, a preferred embodiment of a contactless system according to the invention for inspecting a solder joint 11 with a conductor 13 includes stimulation means such as a fluid jet 15 for stimulating the conductor 13 to vibrate; detection means, generally designated 17, physically isolated from the conductor 13 for detecting any vibrations of the conductor 13; and output means such as a spectrum analyzer 19 responsive to the detection means 17 to provide an output indicative of the quality of the solder joint.

The solder joint 11 is illustrated as connecting the conductor 13 with a pad (not shown) on a printed circuit board 20; however, the solder joint 11 could instead connect the conductor 13 with something else such as a terminal of an inductor or the like.

The stimulation means preferably comprises, in addition to the jet 15, means (not shown) for providing a fluid to the jet 15 under pressure and means such as a robotic control system (not shown) for aiming the jet 15 at the conductor 13 whereby a pressurized stream of fluid is directed against the conductor 13. The fluid comprises, for example, compressed air.

If a plurality of conductors are located near each other, the fluid may be aimed at all of them at the same time with the result that vibrations are induced in all of them simultaneously. The detection means 17 must be able to focus on a single conductor so as to detect any vibrations induced in that conductor, but it is not necessary for the stimulation means to do so. In fact, a piezoelectric transducer 21 or the like (indicated by broken lines) may be substituted for the jet 15 and acoustically coupled to the circuit board 20 to stimulate vibrations in all the conductors on the board at the same time, so long as the detector 17 can selectively detect vibrations in each conductor individually.

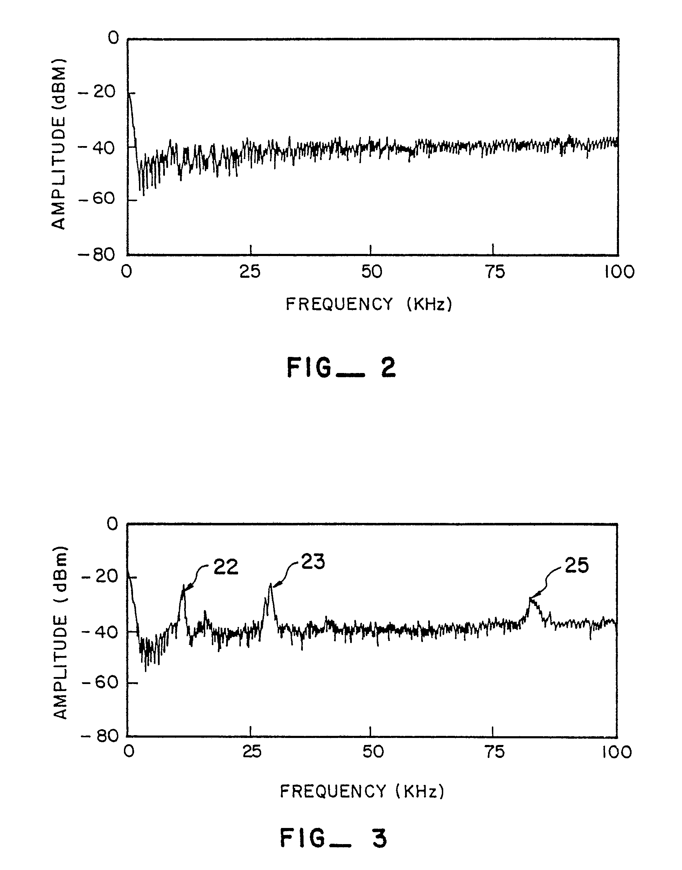

The output preferably comprises an amplitude-frequency plot of the vibrations detected in the conductor 13. By way of example, the results of a test performed on a conductor having a known good solder joint and on one having a known defective solder joint are shown in FIGURES 2 and 3, respectively. The good solder joint resulted in an amplitude-frequency plot in which the amplitude of the vibrations stayed between about -40 and -60 dBm within a frequency range of about 5 KHz to 100 KHz, as depicted in FIGURE 2. FIGURE 3 depicts a plot corresponding with the defective solder joint; this plot has noticeable amplitude peaks 22, 23 and 25 having magnitudes of nearly -20 dBm at frequencies of about 10, 30 and 80 KHz, respectively.

Of course, the plots shown in FIGURES 2 and 3 are not to be taken as depicting actual values which will be obtained under all test conditions. These plots are merely indicative of the fact that easily observable differences based on the presence or absence of certain vibratory frequencies at relatively high amplitudes will be present. The actual magnitudes of vibration amplitudes which will be detected at various frequencies will depend on such physical parameters as the length and density of the conductor, the type and amount of solder in the joint, and various characteristics of the circuit board. It may be, for example, that for a given circuit board and component configuration the presence of peaks at certain frequencies will be associated with good joints and the absence of such peaks will indicate a bad joint or even that good and bad joints will produce amplitude peaks at different frequencies.

The detection means 17 preferably comprises means, generally designated 27, for causing an incident energy beam as represented by a broken line 29 to be modulated according to any vibrations of the conductor, and means, generally designated 31, for detecting any modulations carried by the energy beam. The incident beam 29 preferably comprises coherent optical energy such as that generated by a laser. Means such as an optical focusing device 33 directs the beam 29 onto a surface of the conductor 13 whereby a portion of the beam, as indicated by a broken line 35, is reflected back toward the detection means 17.

More particularly, the detection means 17 comprises a laser Doppler vibrometer ("LDV") 37 (sometimes referred to as a "velocimeter") which includes a laser 39 and a receiver 41. The laser 39 provides the incident energy beam 29. The beam 29 undergoes a Doppler shift which is caused by the vibrations of the conductor 13 as the beam is reflected from the surface of the conductor 13, and this Doppler shift is detected by the receiver 41. The receiver 41 uses the detected Doppler shift to provide a signal indicative of the vibrations of the conductor 13, and this signal is applied to the spectrum analyzer 19 as indicated by a connection line 43 between the receiver 41 and the analyzer 19.

The reflected beam 35 is shown as traversing a different path from that of the incident beam 29. However, a beam-splitter or other optical device (not shown) may be included within the vibrometer 37 such that the paths of the incident and reflected beams are coincident over at least part of the route between the vibrometer 37 and the conductor 13.

The conductor 13 shown in FIGURE 1 comprises a J-shaped lead emanating from a component 45. However, the invention is not limited to the testing of conductors and solder joints configured precisely as shown but is readily adaptable to the testing of solder joints involving various shapes of components and leads.

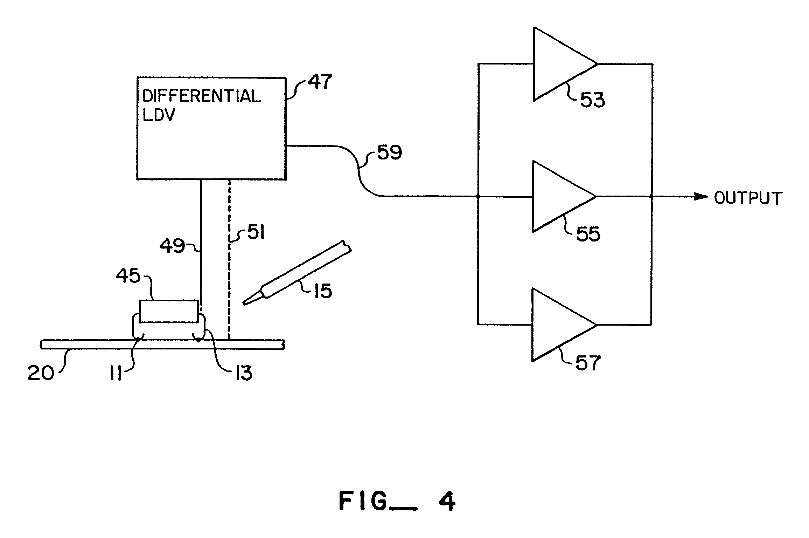

FIGURE 4 depicts an embodiment of the invention having two features which differ from those of the embodiment shown in FIGURE 1. First, a differential LDV 47 serves as the detection means in place of the LDV 37. The differential LDV 47 provides two laser beams, a first beam 49 which is focused on the component lead 13 and a second beam 51 which is focused on the circuit board 20. The first beam 49 is used to detect vibrations in the component lead 13, and the second beam 51 is used to detect vibrations in the board 20. The differential LDV effectively subtracts any vibrations present in the board 20 from the vibrations present in the conductor 13, thereby providing an output which includes only vibrations unique to the conductor 13. Under some conditions, such an output offers improved performance.

Second, a plurality of tuned filters 53, 55 and 57 serve as the output means in place of the spectrum analyzer 19. The filters 53, 55 and 57 receive the signal indicative of the vibrations as indicated by a connection line 59. The filters provide an output having less information than the output of the spectrum analyzer but they provide it much faster. Often a defective solder joint is detectable by examining the amplitudes of only one or a few key frequencies rather than the entire frequency spectrum of the vibrations, and under such circumstances the filters are advantageously used to provide the desired output faster and more economically than the spectrum analyzer.

It will be apparent that only one filter, rather that the plurality shown in FIGURE 4, may be sufficient, or that some other number than three may be used as desired. Also, filters may be used with the detection means 17 of FIGURE 1 and the differential LDV 47 may be used with the spectrum analyzer 19 as desired.

From the foregoing it will be appreciated that a solder joint inspection system embodying the invention can rapidly and accurately inspect a large number of solder joints on a printed circuit board having a high component density. The system is easy to use and is readily adaptable to a wide variety of component and circuit board configurations. Manufacturing quality control of printed circuit boards assembled with the assistance of the system provided by the invention is significantly improved over that which can be attained by visual inspection, and the cost of performing the inspections is significantly lowered.

Although certain specific embodiments of the invention have been described and illustrated, the invention is not to be limited to the specific forms or arrangements of parts so described and illustrated, and various modifications and changes can be made without departing from the scope and spirit of the invention. Therefore, within the scope of the appended claims the invention may be practiced otherwise than as specifically described and illustrated.

## Claims

1. A contactless inspection system for inspecting a solder joint with an electrical conductor, the system comprising:
stimulation means for stimulating the conductor to vibrate;
detection means, physically isolated from the conductor, for detecting any vibrations of the conductor; and
output means, responsive to the detection means to provide an output indicative of the quality of the solder joint.

2. An inspection system according to claim 1 wherein the stimulation means comprises a fluid jet, means for providing a fluid to the jet under pressure, and means for aiming the jet at the conductor whereby a pressurized stream of fluid is directed against the conductor.

3. An inspection system according to claim 2 wherein the fluid comprises air.

4. An inspection system according to claim 1 wherein the output means comprises a tuned filter.

5. An inspection system according to claim 1 wherein the output comprises an amplitude-frequency plot of the vibrations.

6. An inspection system according to claim 4 wherein the output means comprises a spectrum analyzer.

7. A contactless inspection system for inspecting a solder joint with an electrical conductor, the system comprising:
stimulation means for stimulating the conductor to vibrate;
detection means, physically isolated from the conductor, for detecting any vibrations of the conductor, the detection means including means for causing an energy beam to be modulated according to any vibrations of the conductor and means for detecting any modulations carried by the energy beam; and
output means, responsive to the detection means to provide an output indicative of the quality of the solder joint.

8. An inspection system according to claim 7 wherein the stimulation means comprises a fluid jet, means for providing a fluid to the jet under pressure, and means for aiming the jet at the conductor whereby a pressurized stream of fluid is directed against the conductor.

9. An inspection system according to claim 8 wherein the fluid comprises air.

10. An inspection system according to claim 7 wherein the output means comprises a tuned filter.

11. An inspection system according to claim 7 wherein the output comprises an amplitude-frequency plot of the vibrations.

12. An inspection system according to claim 11 wherein the output means comprises a spectrum analyzer.

13. An inspection system according to claim 7 wherein the energy beam comprises coherent optical energy.

14. An inspection system according to claim 7 wherein the means for causing the beam to be modulated comprises means for directing the beam onto a surface of the conductor whereby a portion of the beam is reflected therefrom.

15. A contactless inspection system for inspecting a solder joint with an electrical conductor, the system comprising:
stimulation means for stimulating the conductor to vibrate;
a laser Doppler vibrometer for detecting any vibrations of the conductor; and

output means, responsive to the detection means to provide an output indicative of the quality of the solder joint.

16. An inspection system according to claim 15 wherein the stimulation means comprises a fluid jet, means for providing a fluid to the jet under pressure, and means for aiming the jet at the conductor whereby a pressurized stream of fluid is directed against the conductor.

17. An inspection system according to claim 16 wherein the fluid comprises air.

18. An inspection system according to claim 15 wherein the output means comprises a tuned filter.

19. An inspection system according to claim 15 wherein the output comprises an amplitude-frequency plot of the vibrations.

20. An inspection system according to claim 19 wherein the output means comprises a spectrum analyzer.

21. An inspection system according to claim 15 wherein the vibrometer comprises a differential vibrometer.

22. A method of inspecting a solder joint with an electrical conductor, the method comprising:
stimulating the conductor to vibrate;
detecting any vibrations of the conductor by means of a detector which is physically isolated from the conductor; and
providing an output indicative of the quality of the solder joint.

23. A method according to claim 22 wherein the conductor is stimulated by directing a pressurized stream of fluid against the conductor.

24. A method according to claim 22 wherein the output comprises an amplitude-frequency plot of the vibrations.

25. A method according to claim 22 wherein the step of detecting the vibrations comprises modulating an energy beam with any vibrations of the conductor and detecting any modulations carried by the energy beam;

26. A method according to claim 25 wherein the beam is modulated by directing it onto a surface of the conductor whereby a portion of the beam is reflected therefrom.

SPECTRUM ANALYZER

FIG—1

FIG__ 2

FIG__ 3

FIG_ 4

EP 0 372 812 A2